Europäisches Patentamt

(19) European Patent Office

Office européen des brevets

(11) Publication number: **0 061 350**
**B1**

(12) **EUROPEAN PATENT SPECIFICATION**

(45) Date of publication of patent specification: **17.09.86**

(51) Int. Cl.⁴: **H 01 L 21/308, H 05 K 3/00, G 03 F 7/26**

(21) Application number: **82301537.5**

(22) Date of filing: **24.03.82**

(54) **Method of forming pattern.**

(30) Priority: **25.03.81 JP 42317/81**

(43) Date of publication of application:
**29.09.82 Bulletin 82/39**

(45) Publication of the grant of the patent:
**17.09.86 Bulletin 86/38**

(84) Designated Contracting States:
**DE FR GB NL**

(56) References cited:
**WO-A-80/01978**
**DE-A-2 504 500**
**DE-A-2 625 870**
**DE-A-2 635 066**
**DE-A-2 723 933**
**DE-A-2 730 483**
**DE-A-2 748 401**
**DE-A-2 930 290**
**DE-B-2 302 116**
**US-A-3 880 684**
**US-A-4 133 907**

ELEKTRONIK, vol. 28, no. 11, May 31, 1979,
München, B.MAVITY, T.C. MC CARTHY
"Magnetblasenspeicher-Bausteine und
Systeme", pages 45-52

(73) Proprietor: **Hitachi, Ltd.**
**5-1, Marunouchi 1-chome**
**Chiyoda-ku Tokyo 100 (JP)**

(72) Inventor: **Mochiji, Kozo**
**77-26, Fujimicho-6-chome**
**Tachikawa-shi (JP)**
Inventor: **Wada, Yasuo**
**14-5, Otsuka-6-chome Bunkyo-ku**
**Tokyo (JP)**
Inventor: **Ohyu, Kiyonori**
**19-7, Fujimidaira-2-chome Hamuramachi**
**Nishitama-gun Tokyo (JP)**

(74) Representative: **Goldin, Douglas Michael et al**
**J.A. KEMP & CO. 14, South Square Gray's Inn**
**London WC1R 5EU (GB)**

(56) References cited:
**I. RUGE "Halbleiter-Technologie", 1975,
SPRINGER VERLAG, Berlin, Heidelberg, New
York**

**A. H. ESCHENFELDER "Magnetic bubble
technology", 1980, SPRINGER VERLAG, Berlin,
Heidelberg, New York, pages 250-254**

Courier Press, Leamington Spa, England.

EP 0 061 350 B1

## Description

The present invention relates to a method of forming a pattern, and more particularly to a method of forming a pattern in which a desired fine pattern can be formed with high accuracy through a dryetching technique.

As the demand for high density packaging and high density integration for semiconductor devices and magnetic bubble memory devices becomes greater recently, it is greatly required to develop a method for forming a very fine pattern, small in width of line and in spacing between lines of the mask to be used for fabrication of such devices. As is well known, such a fine pattern is usually formed by the so-called photolithography technique.

In the conventional photolithography technique, ultraviolet rays having a wavelength of about 320 to 500 nm are usually employed, and therefore the width of line and the spacing between lines at a fine pattern are restricted by characteristic properties of light such as diffraction and interference.

In order to obviate the above-mentioned adverse effect resulting from the wavelength of light so that a fine pattern can be formed, a method has been proposed in which for ultraviolet rays, an electron beam or X-rays having a shorter wavelength as compared with the usual ultraviolet rays are employed in place of the usual ultraviolet rays. According to this method, a finer pattern than a pattern obtained by the conventional photolithography can be formed. Especially, the wavelength of an electron beam or X-rays is far shorter than that of the ultraviolet rays. Therefore, when the electron beam or X-rays are employed, the influence of the above-mentioned diffraction and interference is negligible, and a very fine pattern can be formed.

On the other hand, after has been irradiated with the ultraviolet rays, electron beam or X-rays, a resist film is developed to obtain a resist pattern. Then, an etching treatment is carried out using the resist pattern as a mask, and thus exposed portions of an insulating film or a metallic film, which are located beneath the resist film, are etched off to form a wiring pattern and others.

In the etching treatment, the so-called wetetching technique which uses a chemical etchant such as an acid, has been generally employed. However, owing to the side etching and others, it is difficult to form a fine pattern by the wetetching technique. For this reason, the so-called dryetching technique is now employed which does not use any chemical etchant.

In a dryetching technique, etching is carried out by bombarding a workpiece with ions or neutral particles while using, as a mask, film of an appropriate material such as a photoresist. Accordingly, the mask made of the photoresist or the like is required to be highly resistant to the ion bombardment and neutral particle bombardment. However, many of generally used resist materials have poor resistance to such bombardment. This poses a serious problem.

Especially, electron beam resist films presently used in the electron beam lithography which employs an electron beam in place of ultraviolet rays, are lower in resistance to dryetching than photoresist films. Therefore, when dryetching is carried out while using the electron beam resist as a mask, the mask gets out of shape in the dryetching process.

Accordingly, even when a fine resist pattern has been formed with high accuracy by irradiating a resist film with an electron beam and then developing the resist film, it is difficult to form a desired fine pattern with high accuracy by the dryetching which uses the resist pattern as a mask.

An object of the present invention is to provide a method of forming a pattern which can solve the above-mentioned problem of the prior art, and in which a resist pattern is made high in resistance to dryetching so that a fine pattern can be formed with a high accuracy.

In order to attain the above object, according to the present invention, a resist pattern formed by exposing and developing treatments is implanted with an ion, and thus the resistance of the resist pattern to dryetching is greatly enhanced.

The invention will be well understood from the following description of preferred embodiments with reference to the accompanying drawings in which:

Figs. 1a to 1d are views for showing steps in an embodiment of a method of forming a pattern according to the present invention.

Fig. 2 is a graph showing relations between an ion dose and a dryetching rate for a resist film made of polymethyl methacrylate in the case where the resist film is implanted with a phosphorous ion or an argon ion.

Figs. 3a to 3c are microphotographs for showing an advantage of the present invention.

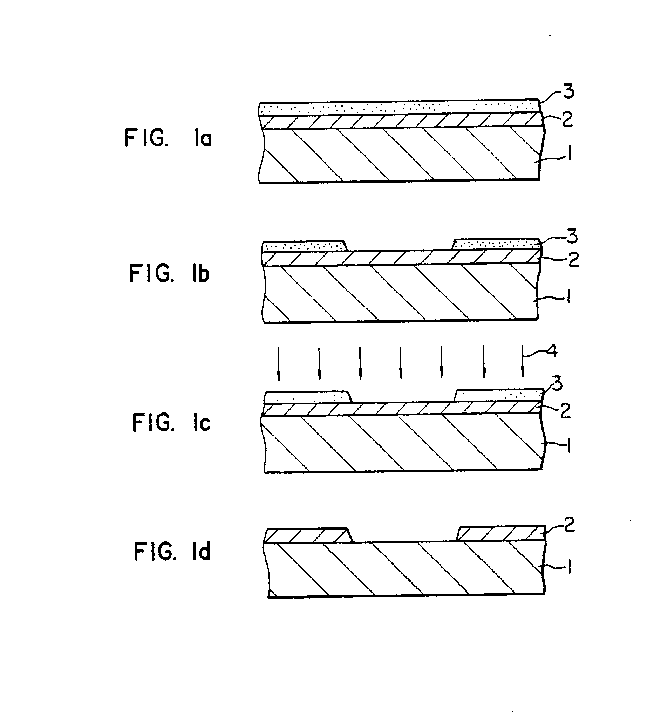

With reference to Figs. 1a to 1c, the explanation will be made of the steps in an embodiment of the present invention. First, a polymethyl methacrylate (hereinafter referred to as "PMMA") film 3 acting as a resist film is formed, to a thickness of about 1 $\mu$m, on a phosphosilicate glass (hereinafter referred to as "PSG") film 2 which is formed on a silicon substrate 1 and serves as a workpiece, as shown in Fig. 1a. After the structure shown in Fig. 1a has been pre-baked at a temperature of 150 to 170°C for 20 minutes, a desired portion of the PMMA film 3 is irradiated with an electron beam and then the PMMA film 3 is developed. Thus, the portion of the film 3 irradiated with the electron beam is removed, and such resist pattern 3 as shown in Fig. 1b is formed. The implant dose of electrons in the above-mentioned process may take any value, but is made nearly equal to $1 \times 10^{-4}$ C/cm$^2$ in the present embodiment.

Further, the development is carried out by dipping the structure into a solution which contains one part of methyl acetate and nine parts of isoamyl acetate, at 25°C for 3 minutes.

Next, the entire area on the surface of the structure is implanted with an argon ion 4, as shown in Fig. 1c. The ion implantation is carried out by the use of an ion implantation apparatus. When the resist pattern 3 is implanted with the high-energy ion, the molecular structure of the PMMA film forming the resist pattern is destroyed. Thus, the PMMA film substantially assumes a carbonized state, and therefore is very stable to heat.

In the succeeding step, the PSG film 2 is subjected to reactive sputter etching while using the ion-implanted resist pattern 3 as a mask. The reactive sputter etching is carried out in a well known parallel plates type reactive sputter etching apparatus using $C_4H_8$ as a reactive gas. Thus, an exposed portion of the PSG film is etched off while keeping the portions under the resist pattern 3 substantially unetched because the resist pattern 3 is very resistive to dryetching. After the exposed portion of the PSG film 2 has been etched off, the resist pattern 3 is removed by an oxygen plasma. Thus, the pattern formed of the PSG film 2 is obtained as shown in Fig. 1d.

The detailed mechanism, by which the ion implantation can enhance the resistance of a photoresist film to dryetching, is not clear. However, the study of photoresist films made by the use of an infrared spectrometer shows that when a photoresist film is implanted with ions, a side chain portion in the molecular structure of the resist film disappears. Further, it is found that the heat resistance of a resist film is greatly enhanced by ion implantation. It is considered from these facts that unstable side chains in the resist film are removed by high-energy ions and the stable principal chain is left unchanged, that is, the resist film is partially carbonized, and thus the resistance of the resist film to the impact of plasma and others is enhanced.

When the ion dose in the resist film is less than about $1 \times 10^{13}/cm^2$, the effect to enhance the resistance of the resist film to dryetching is very low. Accordingly, it is preferred that the ion dose is not less than $1 \times 10^{13}/cm^2$. The resistance to dryetching is high as the ion dose is larger. on the other hand, when implanted with an ion, the resist film is etched due to ion bombardment. In more detail, the thickness of the resist film is decreased by about 500 nm, when the resist film is implanted with ions at a dose of $1 \times 10^{15}/cm^2$.

In the electron beam lithography technique, a maximum thickness of a resist film which allows a fine resist pattern to be exactly formed, is about 1 μm. Further, when the thickness of a resist pattern is less than about 500 nm, the resist pattern cannot act as a mask in a satisfactory manner.

Accordingly, it is preferred that a reduction in the thickness of a resist film caused by the ion implantation is less than about 500 nm. That is, the ion dose is preferably made less than $1 \times 10^{15}/cm^2$.

As is evident from the above-mentioned explanation, a preferable ion dose in the present invention lies in a range from about $1 \times 10^{13}$ to about $1 \times 10^{15}/cm^2$.

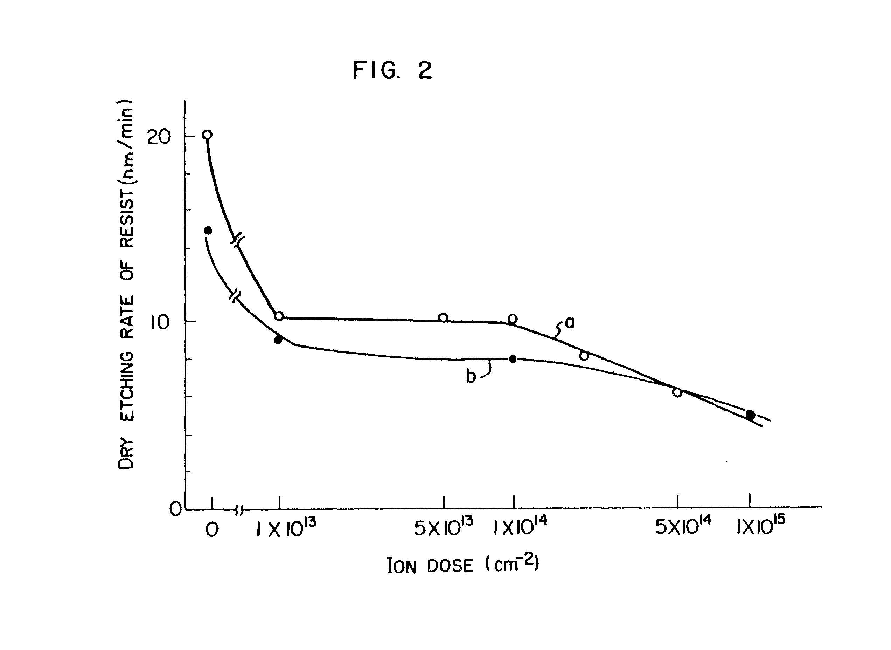

Fig. 2 shows relations between an ion dose and a dryetching rate for a resist pattern in the case where resist patterns made of PMMA and implanted with phosphorous and argon ions at an implant energy of 150 KeV are used as masks in dryetching. Curves a and b shown in Fig. 2 indicate the above-mentioned relation for the resist pattern implanted with phosphorous ions and that for the resist pattern implanted with argon ions, respectively.

As is apparent from Fig. 2, when a resist film is implanted with phosphorous or argon ions at a dose of more than $1 \times 10^{13}/cm^2$, the dryetching rate for the resist film is greatly decreased, and therefore the ion implantation for a mask is very effective in enhancing the resistance of the mask to dryetching.

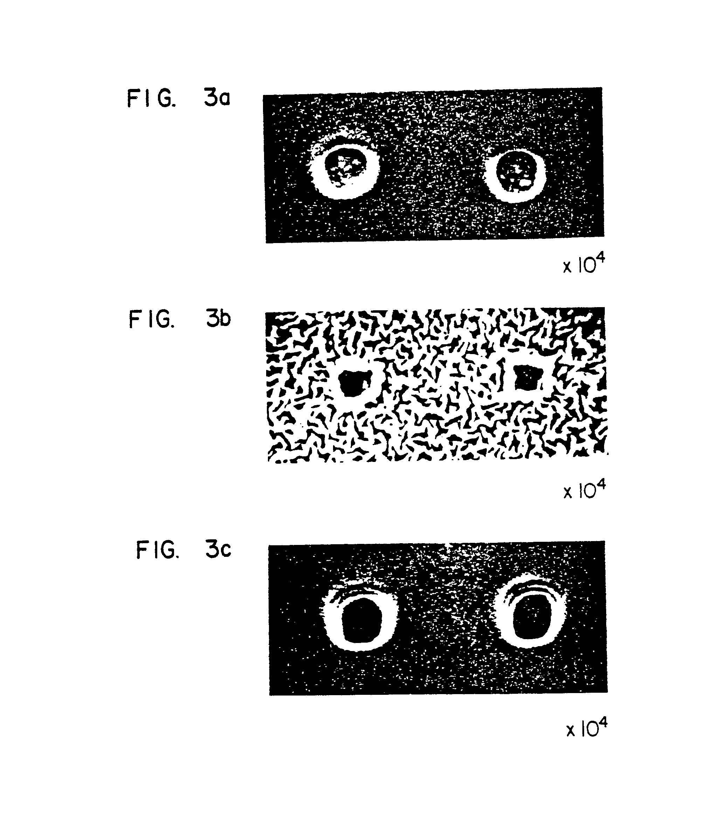

Figs. 3a to 3c are microphotographs for showing an advantage of the present invention. When such a resist pattern as shown in Fig. 3a is formed using a PMMA film and then plasma etching is carried out for 20 minutes while using the resist pattern which is not yet subjected to implantation treatment, as a mask, the resist pattern suffers great damage and the shape of the resist pattern is considerably varied, as shown in Fig. 3b.

However, when the plasma etching is carried out after the resist pattern has been implanted with phosphorous ions at a dose of $2 \times 10^{14}/cm^2$, the resist pattern receives no damage, as shown in Fig. 3c. Thus, the advantage of the present invention can be observed.

A resist material which can remarkably show such advantage of the present invention, is not is not limited to PMMA, but a positive electron beam resist or photoresist such as poly isopropenyl-ketone (PMIPK) or hexafluorobutyl methacrylate (FBM) and a negative electron beam resist or photoresist such as poly glycidyl methacrylate (PGMA) can be used in the present invention. When an electron beam resist is implanted with an ion, the advantage of the present invention is especially remarkable.

As explained in the foregoing description, according to the present invention, a resist pattern is implanted with an ion to have high resistance to dryetching, and various workpieces are etched by the dryetching technique using the ion-implanted resist pattern as mask.

As mentioned previously, the resistance of a resist pattern to dryetching is enhanced by implanting the resist pattern with ion, for the reasons that each of molecules making up the resist pattern is disintegrated by ion bombardment in the implantation process, that volatile components produced by the disintegration of molecule escape from the resist pattern, and that the resist pattern is thus converted into a material similar to a carbide.

The degree of disintegration of a molecule caused by ion bombardment is substantially independent of the kind of the resist material, and is greatly affected by the dose of implant ion. Accordingly, though Fig. 2 shows the relations obtained in the case where a resist pattern made of PMMA is employed, relations similar to those shown in Fig. 2 are obtained in the case where one of various resist materials other than PMMA is employed. In either case, the resistance of a resist pattern to dryetching can be sufficiently enhanced by implanting the resist pattern with ions at a dose of more than about $1 \times 10^{13}/cm^2$. Further, a preferable maximum dose of implant ions in the latter case is nearly equal to $1 \times 10^{15}/cm^2$, as in the former case.

Further, it is needless to say that a resist pattern, which is to be implanted with an ion in accordance with the present invention, is formed by selectively irradiating a resist film formed on a workpiece with ultraviolet rays, an electron beam, X-rays, or the like in the same manner as in an ordinary case and by removing an undesired portion of the resist film by developing treatment.

When a resist pattern is implanted with ions of a small atomic weight such as hydrogen ions, the effect to enhance the resistance of the resist pattern to dryetching is low. However, various ions used in an ordinary ion implantation process for fabricating a semiconductor device, such as ions of arsenic, phosphorous, boron, aluminum, gallium and antimony, can be used in the present invention. Further, the previously-mentioned argon ions and neon ions may be used. Furthermore, a resist pattern may be implanted with two or more different kinds of ions.

The depth of an implant region is determined by the implant energy of ion. The thickness of a resist pattern used in fabrication of a semiconductor device is about 2 μm when using irradiation of ultraviolet rays and about 1 μm when using irradiation of electron beam. However, it is required in the present invention to enhance the resistance to dryetching only in a surface region of the resist pattern, and therefore an implant energy of about 100 to 150 KeV is employed in ordinary cases. It is a matter of course that the implant energy may be made higher than 150 KeV to enhance the resistance to dryetching in the inner part of the resist pattern. However, when the implant energy is extremely low, the effect to enhance the resistance of a resist film to dryetching is low. Accordingly, it is preferable to avoid the use of an implant energy of less than 50 or 70 KeV.

## Claims

1. A method of forming a pattern on a workpiece suitable for treatment by dry etching comprising the steps of:

forming a resist film on a surface of the workpiece;

irradiating a desired region of the resist film with ultraviolet rays, an electron beam or X-rays to alter the solubility of that region;

developing the resist film to remove the irradiated region and thereby form a resist mask;

implanting the resist mask with ions; and

dry etching the exposed portion of the workpiece which is not covered by the ion-implanted resist mask.

2. A method according to claim 1, wherein the resist pattern is implanted with an ion dose of $1 \times 10^{13}$ to $1 \times 10^{15}$ cm$^{-2}$.

3. A method according to claim 1 or 2, wherein the ions are selected from one or more of: arsenic, phosphorous, boron, aluminium, gallium, antimony, argon and neon ions.

4. A method according to claim 1, 2 or 3, wherein the resist mask is implanted with ions with an implant energy of 100 to 150 KeV.

5. A method according to any one of the preceding claims wherein the resist film comprises polymethyl methacrylate, polyisopropenylketone, hexafluorobutyl methacrylate or poly glycidyl methacrylate.

6. A method according to any one of the preceding claims wherein the dry etching is reactive sputter etching or plasma etching.

7. A method according to any one of the preceding claims wherein, in a final step, the ion-implanted resist mask is removed by oxygen plasma.

8. A semiconductor device incorporating the ion-implanted resist mask and the pattern produced according to any one of claims 1 to 6.

9. A magnetic bubble memory device incorporating the ion-implanted resist mask and the pattern produced according to any one of claims 1 to 6.

## Patentansprüche

1. Verfahren zur Herstellung von Mustern auf einem Werkstück, das zur Bearbeitung durch Trokkenätzen geeignet ist, mit folgenden Verfahrensschritten:

Ausbilden eines Resistfilmes auf der Oberfläche des Werkstücks;

Bestrahlen eines ausgewählten Gebietes des Resistfilmes mit ultravioletten Strahlen, einem Elektronenstrahl oder Röntgenstrahlen, um die Löslichkeit dieses Gebietes zu ändern;

Entwickeln des Resistfilmes, um das bestrahlte Gebiet zu entfernen und auf diese Weise eine Resist-Maske zu bilden;

Implantieren der Resistmaske mit Ionen; und

Trockenätzen des freigelegten Teiles des Werkstücks, welches nicht von der ionenimplantierten Resistmaske bedeckt ist.

2. Verfahren nach Anspruch 1, bei dem das Resistmuster mit einer Ionendosis von $1 \times 10^{13}$ bis $1 \times 10^{15}$ cm$^{-2}$ implantiert wird.

3. Verfahren nach Anspruch 1 oder 2, bei dem Ionen aus einem oder mehreren der folgenden Elemente ausgewählt sind: Arsen, Phosphor, Bor, Aluminium, Gallium, Antimon, Argon und Neonionen.

4. Verfahren nach einem der Ansprüche 1 bis 3, bei dem die Resistmaske mit Ionen mit einer Implantationsenergie von 100 Kev bis 150 KeV implantiert wird.

5. Verfahren nach einem der vorangehenden Ansprüche, bei dem der Resistfilm Polymethylmethacrylat, Polyisopropenylketon, Hexafluorobutylmethacrylat oder Polyglycidylmethacrylat aufweist.

6. Verfahren nach einem der vorangehenden Ansprüche, bei dem das Trockenätzen ein reaktives Sputterätzen oder ein Plasmaätzen ist.

7. Verfahren nach einem der vorangehenden Ansprüche bei dem als letzter Schritt die ionenimplantierte Resistmaske durch ein Sauerstoffplasma entfernt wird.

8. Halbleitervorrichtung mit einer ionenplantierten Resistmaske und einem Muster, das nach einem der Ansprüche 1 bis 6 hergestellt ist.

9. Magnetblasen-Speichervorrichtung mit einer ionen implantierten Resistmaske und einem Muster, das nach einem Ansprüche 1 bis 6 hergestellt ist.

**Revendications**

1. Procédé pour former un dessin sur une pièce à traiter, convenant pour un traitement par corrosion à sec et incluant les phases opératoires consistant à:

— former une pellicule de résine sur une surface de la pièce à traiter;

— irradier une région désirée de la pellicule de résine avec un rayonnement ultraviolet, un faisceau d'électrons ou des rayons X de manière à modifier la solubilité de cette région;

— développer la pellicule de résine de manière à éliminer la région irradiée et former de ce fait un masque de résine;

— implanter des ions dans le masque de résine; et

— réaliser la corrosion à sec la partie à nu de la pièce à traiter, qui n'est pas recouverte par le masque de résine ayant subi une implantation ionique.

2. Procédé selon la revendication 1, selon lequel on réalise dans le dessin formé de résine une implantation avec une dose d'ions de $1 \times 10^{13}$ à $1 \times 10^{15}$ cm$^{-2}$.

3. Procédé selon la revendication 1 ou 2, selon lequel les ions sont choisis à partir d'un ou de plusieurs ions: ions d'arsenic, de phosphore, de bore, d'aluminium, de gallium, d'antimoine, d'argon et de néon.

4. Procédé selon la revendication 1, 2 ou 3, selon lequel l'implantation d'ions dans le masque de résine s'effectue avec une énergie d'implantation comprise entre 100 et 150 keV.

5. Procédé selon l'une quelconque des revendications précédentes, selon lequel la pellicule de résine comprend du polyméthacrylate de méthyle, de la polyisopropénylcétone, du méthacrylate d'hexafluorobutyle ou du polyméthacrylate de glycidyle.

6. Procédé selon l'une quelconque des revendications précédentes, selon lequel la corrosion à sec est une corrosion par pulvérisation réactive ou une corrosion plasmatique.

7. Procédé selon l'une quelconque des revendications précédentes, selon lequel, au cours d'une phase finale, le masque de résine ayant subi une implantation ionique est éliminé par un plasma oxygène.

8. Dispositif à semiconducteurs comportant le masque de résine ayant subi l'implantation ionique et le dessin fabriqué conformément à l'une quelconque des revendications 1 à 6.

9. Dispositif de mémoire à bulles magnétiques comportant le masque de résine ayant subi l'implantation ionique et le dessin fabriqué conformément à l'une quelconque des revendications 1 à 6.

FIG. Ia

FIG. Ib

FIG. Ic

FIG. Id

FIG. 2

FIG. 3a

x $10^4$

FIG. 3b

x $10^4$

FIG. 3c

x $10^4$